(19)

Europäisches Patentamt
European Patent Office
Office européen des brevets

(11) **EP 4 213 395 B1**

(12) **EUROPEAN PATENT SPECIFICATION**

(45) Date of publication and mention
of the grant of the patent:
**08.07.2026 Bulletin 2026/28**

(21) Application number: **23159505.9**

(22) Date of filing: **12.08.2016**

(51) International Patent Classification (IPC):
*H03M 1/12* (2006.01)    *H04R 19/04* (2006.01)
*H03F 3/45* (2006.01)    *H04R 29/00* (2006.01)
*H04R 3/00* (2006.01)    *H03F 3/00* (2006.01)
*G11C 27/02* (2006.01)    *H03M 3/02* (2006.01)

(52) Cooperative Patent Classification (CPC):
**H03F 3/005; H03F 3/45475; H03F 3/45959;
H03M 1/1295; H03M 3/494; H03M 3/496;
H04R 3/00; H04R 29/004;** G11C 27/024;
H03F 2203/45421; H03F 2203/45512;
H03F 2203/45544; H03F 2203/45551;
H04R 2499/11

(54) **ANALOG-TO-DIGITAL CONVERTER ADAPTED TO OPERATE WITH DIFFERENT INPUT DEVICE CONFIGURATIONS**

ANALOG-DIGITAL-WANDLER, DER FÜR DEN BETRIEB MIT VERSCHIEDENEN KONFIGURATIONEN VON EINGABEGERÄTEN AUSGELEGT IST

CONVERTISSEUR ANALOGIQUE-NUMÉRIQUE CONÇU POUR FONCTIONNER AVEC DIFFÉRENTES CONFIGURATIONS DE PÉRIPHÉRIQUES D'ENTRÉE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.08.2015 US 201514826996**

(43) Date of publication of application:
**19.07.2023 Bulletin 2023/29**

(62) Document number(s) of the earlier application(s) in accordance with Art. 76 EPC:
**16757778.2 / 3 335 319**

(73) Proprietor: **Cirrus Logic International Semiconductor, Ltd.**
**Edinburgh EH3 9EG (GB)**

(72) Inventors:
• **ZANBAGHI, Ramin**
**Austin, 78739 (US)**
• **BRENNAN, Aaron**
**Austin, 78737 (US)**
• **ALLEN, Daniel**
**Austin, 78704 (US)**
• **MELANSON, John**
**Austin, 78703 (US)**

(74) Representative: **Haseltine Lake Kempner LLP**
**One Portwall Square**
**Portwall Lane**
**Bristol BS1 6BH (GB)**

(56) References cited:
**CA-A1- 2 273 658      US-A1- 2011 276 975**
**US-B1- 8 907 703**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**CROSS-REFERENCE TO RELATED PATENT APPLICATIONS**

This application claims the benefit of U.S. Patent Application No. 15/236,163 to Zanbaghi et al. filed August 12, 2016 and entitled "Phase Shorting Switch," which is a continuation-in-part of U.S. Patent Application No. 14/826,996 to Zanbaghi et al. filed August 14, 2015 and entitled "Dual Processing Paths for Differential Mode and Common Mode Signals for an Adaptable Analog-To-Digital Converter (ADC) Topology,".

**FIELD OF THE DISCLOSURE**

The instant disclosure relates to analog-to-digital converters (ADCs). More specifically, portions of this disclosure relate to adapting ADCs to operate with different input device configurations.

**BACKGROUND**

Microphones generate electrical signals representative of noises and sounds in the environment around the microphone. Microphones are important devices for many electronic devices because sound, and in particular speech, is one of the most important manners of interaction between a human and an electronic device and a human to another human through an electronic device. Microphones generally produce analog signals, but processors within electronic devices are generally digital components that operate on digital signals. Thus, the analog signals of the microphones must be converted to digital signals for further processing within an electronic device. For example, the analog microphone output may be converted to a digital signal to allow an individual's speech to be transmitted from one cellular phone to another cellular phone. In another example, the analog microphone output may be converted to a digital signal to allow a cellular phone to detect speech commands from a user. The component coupled to the microphone for converting the analog signal to a digital signal is an analog-to-digital converter (ADC).

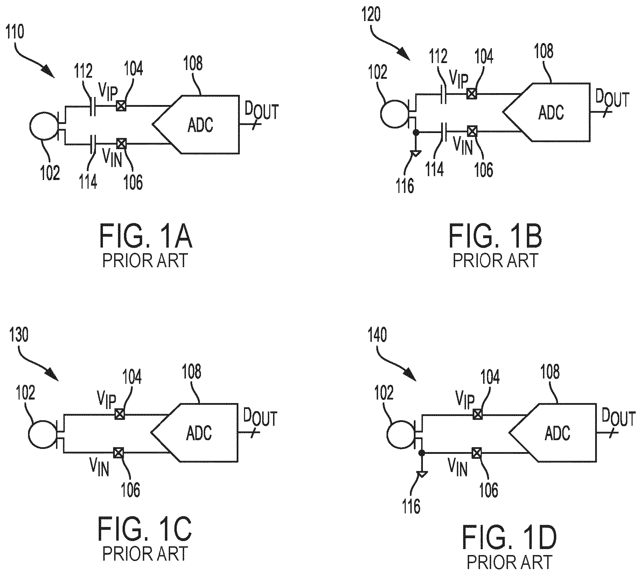

ADCs are thus important components in electronic devices. One complication with the use of ADCs is that the coupling configuration between the microphone and the ADC changes how the ADC processes the analog output of the microphone to generate a digital representation of the microphone output. That is, an ADC must be matched with the particular microphone coupled to the ADC. This restriction inhibits the ability of a user to use any microphone with their electronic devices. Further, this restriction inhibits the ability of a manufacturer to substitute different microphones due to supply shortages. Some different coupling configurations are shown in FIGURES 1A-1D.

Microphones are either fully-differential (FD) or pseudo-differential (PD) and either AC-coupled or DC-coupled into an analog-to-digital converter (ADC). Thus, there are at least four different microphone topology configurations requiring different operations from and interfaces with an ADC. FIGURE 1A illustrates an AC-coupled fully-differential configuration for a microphone and ADC. A microphone 102 may provide outputs 104 and 106. The outputs 104 and 106 are also the inputs to ADC 108, which generates a $D_{out}$ digital signal containing a digital representation of sounds captured by the microphone 102. In AC-coupled configurations, such as FIGURE 1A, capacitors 112 and 114 are coupled between the microphone 102 and the ADC 108. The capacitors 112 and 114, along with input impedance of the ADC 108, create a high-pass filter to block DC signals from the microphone 102 from reaching the ADC 108. The capacitors 112 and 114 may be either integrated into a chip along with the ADC 108 or separate from a chip containing the ADC 108. In either case, the capacitors 112 and 114 consume space in an electronic device that increases the dimensions and thickness of the electronic device. Similar to FIGURE 1A, FIGURE 1B illustrates an AC-coupled pseudo-differential configuration for a microphone and ADC. The pseudo-differential configuration 120 of FIGURE 1B is similar to the fully-differential configuration 110 of FIGURE 1A, but with one terminal of the microphone 102 grounded to node 116.

Alternatively to the AC-coupled topologies of FIGURES 1A and 1B, DC-coupled topologies may be implemented to interfacing an ADC with a microphone. DC-coupled microphone topologies do not require capacitors 112 and 114 to block the DC value of the microphone outputs. Eliminating the capacitors reduces cost and size, but requires extra processing to make the ADC compatible with fully-differential (FD) and pseudo-differential (PD) microphones. FIGURE 1C and FIGURE 1D illustrate a DC-coupled fully-differential (FD) configuration 130 and a DC-coupled pseudo-differential (PD) configuration 140, respectively. One example of the extra processing is that a fully-differential (FD) microphone 102 may provide output values of $V_{in}$ and $V_{ip}$, but these values may be mismatched from each other and also from the desired DC value for correct operation of the ADC. Another example of a configuration requiring additional processing is that of a pseudo-differential (PD) microphone in which the $V_{in}$ signal is connected to ground 116. In both of these examples, the ADC 108 must apply processing specific to the microphone configuration of either FIGURE 1C or FIGURE 1D.

As described above, each of the four configurations of microphone topology shown in FIGURE 1A, FIGURE 1B, FIGURE 1C, and FIGURE 1D require different operation and interfacing with an ADC. For example, AC-coupled microphones require a capacitor at the input of the ADC to block DC signals. As another example, AC-coupled microphones require a common mode voltage generator coupled to the ADC to set the DC values of the inputs $V_{in}$ and $V_{ip}$. As yet another example, a DC-coupled fully-differential microphone requires processing by an ADC to match the microphone input signals to a desired DC value. Because of these different requirements, an ADC is conventionally designed to match a specific microphone configuration and is then generally not usable for other microphone configurations.

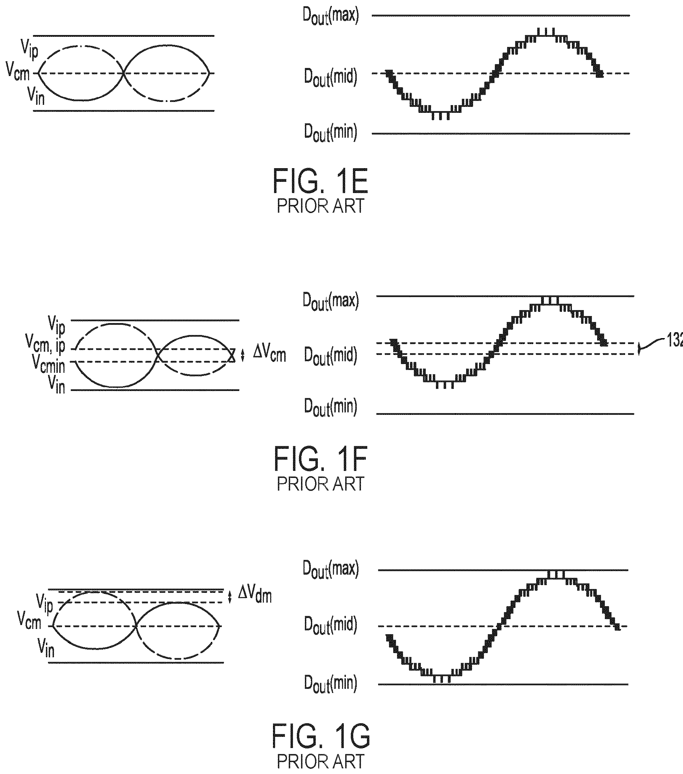

Further, undesired effects may occur when a microphone is coupled through a differential input to interface with the ADC. For example, the common mode (CM) voltage value of fully-differential inputs may not be matched, such that the common mode at input node 104 is different from the common mode at input node 106. Any mismatch between the input CM values may translate into a differential signal that can clip and saturate components the ADC. As another example, an AC signal amplitude mismatch between the differential inputs may produce similar clipping and saturation in the ADC. FIGURES 1E-1G illustrate examples of these undesired effects. The graphs of FIGURES 1E-1G illustrate differential input signals along with a modulator output when input voltages are matched in FIGURE 1E, have mismatched CM voltages in FIGURE 1F, and have mismatched DM voltages in FIGURE 1G. Both the mismatched CM and mismatched DM examples of FIGURE 1F and FIGURE 1G, respectively, may result in quantizer saturation or clipping within an ADC, and thus poor ADC performance. In the mismatched CM of FIGURE 1F, the modulator output experiences a DC shift 132 approximately equal to half of the input CM mismatch value ($\Delta V_{CM}/2$). In the AC amplitude mismatch of FIGURE 1G, there is no offset shift on the output code, but the mismatch causes a gain scaling that may result in a symmetric clipping in the quantizer.

Although undesired effects during fully-differential (FD) operation are described above, undesired effects may also occur during pseudo-differential (PD) operation in which one input is coupled to ground and the other input produces a signal $V_{ip}=V_{cmi}+V_{dm}$. In pseudo-differential (PD) operation, an unbalanced DC shift between differential outputs of components in the ADC may cause swing-driven distortion, such as caused by even harmonics. Such undesired effects also result in poor ADC performance.

Shortcomings mentioned here are only representative and are included simply to highlight that a need exists for improved electrical components, particularly for ADCs employed in consumer-level devices, such as mobile phones. Embodiments described herein address certain shortcomings but not necessarily each and every one described here or known in the art. CA2273658A1 relates to methods and apparatus for cancelling common mode noise in a communication channel, and discloses a noise cancellation circuit for an analogue-to-digital converter comprising differential and common signal paths. US 2011/276975 A1 relates to an audio device that determines the presence and type of a microphone by performing an impedance sense measurement.

## SUMMARY

An analog-to-digital converter (ADC) may be configured, in certain embodiments, to automatically determine the microphone configuration and adjust operation to match the determined microphone configuration. Thus, a single ADC device may be used regardless of the configuration of the microphone at the input of the ADC. This ADC configuration may allow a user to not be familiar with the ADC design of an electronic device before selecting a microphone. This ADC configuration may also allow a manufacturer to manufacture an electronic device with one ADC, but still be able to change the microphone configuration during manufacturing. For example, if a supply shortage of AC-coupled fully-differential microphones occurs, then the manufacturer may switch to an AC-coupled pseudo-differential microphone for some production lots without needing to also replace the ADC in the electronic device. This consideration is important as the ADC may be integrated with other components in the electronic device, which means changing microphone configurations during production may result in significant redesign of the electronic device.

One method of processing microphone input in an ADC to determine microphone configuration is to process the microphone input signals in two processing paths, in which one processing path processes a difference between differential input signals and another processing path processes an average value of the differential input signals. The outputs of these processing paths may be combined to generate a digital signal representative of the analog signal from the microphone. The digital signal contains a digital version of the audio in the environment around the microphone, but may also be used to detect microphone topology and configure aspects of the processing paths to match the detected microphone topology. An apparatus for an ADC may implement the two processing paths as two delta-sigma modulator loops. Feedback from the output digital signal may be converted to analog signals in a digital-to-analog converter (DAC). Operation of these DACs may be adjusted by a controller based on the microphone topology.

The improved operation of an analog-to-digital converter (ADC) may be beneficial in, for example, electronic devices including entertainment devices such as audio or video players, smart phones, tablet computers, and personal computers. The ADC may be coupled to any of numerous microphones within these electronic devices. The ADC can detect and adapt to the microphone topology in use within the electronic device. Although this description refers to ADCs used with microphones, the embodiments of ADCs described herein may be coupled to analog devices other than microphones and the ADCs may process that information in a similar manner. That is, the analog-to-digital converters (ADCs) described herein may be coupled to any analog device that provides an analog signal and that analog signal needs to be processed in digital electronics. Further, the ADCs described herein may be used in any electronic device that processes analog signals. For example, although operation of consumer devices, such as cellular phones, may be described, the ADCs may be used in other components, such as audio equipment.

An ADC may include capability to sense and/or compensate for undesired effects, in addition to or without the capability of detecting the microphone interface configuration described above. For example, a sense node may be provided between differential inputs, wherein the sense node is separated from the differential inputs by two or more switches. The sense node may allow for a measurement of an average voltage of the differential inputs. The average voltage may be obtained activating the switches to neutralize charge stored on sampling capacitors coupled to the differential inputs. That average voltage may be used as common mode (CM) data regarding operation of the ADC. A controller may receive the CM data, along with differential mode (DM) data, and use the CM and DM data to determine undesired effects, such as DC or AC mismatch at the microphone interface or the interface between microphone signals and an analog-to-digital converter (ADC). The controller may then generate a signal for applying compensation to the differential inputs, such as through an auxiliary digital-to-analog converter (DAC), to reduce or eliminate the undesired effects.

The invention is set out in the appended set of claims.

The foregoing has outlined rather broadly certain features and technical advantages of embodiments of the present invention in order that the detailed description that follows may be better understood. Additional features and advantages will be described hereinafter that form the subject of the claims of the invention. Additional features will be better understood from the following description when considered in connection with the accompanying figures. It is to be expressly understood, however, that each of the figures is provided for the purpose of illustration and description only and is not intended to limit the present invention.

**BRIEF DESCRIPTION OF THE DRAWINGS**

For a more complete understanding of the disclosed system and methods, reference is now made to the following descriptions taken in conjunction with the accompanying drawings.

FIGURE 1A is a block diagram illustrating a microphone coupled to an analog-to-digital converter (ADC) in a fully-differential AC-coupled configuration.

FIGURE 1B is a block diagram illustrating a microphone coupled to an analog-to-digital converter (ADC) in a pseudo-differential AC-coupled configuration.

FIGURE 1C is a block diagram illustrating a microphone coupled to an analog-to-digital converter (ADC) in a fully-differential DC-coupled configuration.

FIGURE 1D is a block diagram illustrating a microphone coupled to an analog-to-digital converter (ADC) in a pseudo-differential DC-coupled configuration.

FIGURE 1E is a graph illustrating a modulator digital output code in an analog-to-digital converter (ADC).

FIGURE 1F is a graph illustrating a modulator digital output code in an analog-to-digital converter (ADC) with fully-differential inputs having mismatched common mode (CM) values.

FIGURE 1G is a graph illustrating a modulator digital output code in an analog-to-digital converter (ADC) with fully-differential inputs having mismatched differential mode (DM) values.

FIGURE 2 is a flow chart illustrating a method of detecting and adjusting operation of an analog-to-digital converter (ADC) to match a microphone topology according to one embodiment of the disclosure.

FIGURE 3 is a block diagram illustrating a portion of an analog-to-digital converter (ADC) with two processing paths for processing analog signals according to one embodiment of the disclosure.

FIGURE 4 is a flow chart illustrating a method of converting analog signals to digital signals in an analog-to-digital converter (ADC) with two processing paths according to one embodiment of the disclosure.

FIGURE 5 is a circuit schematic illustrating a portion of an analog-to-digital converter with two processing paths according to one embodiment of the disclosure.

FIGURE 6 is a circuit schematic illustrating digital-to-analog converters (DACs) from the feedback path of the analog-to-digital converter (ADC) according to one embodiment of the disclosure.

FIGURE 7 is a table showing example outputs from a 5-bit analog-to-digital converter (ADC) configured according to one embodiment of the disclosure.

FIGURE 8 is an illustration showing an electronic device with an analog-to-digital converter (ADC) capable of operating microphones of different topologies according to one embodiment of the disclosure.

FIGURE 9 is a circuit schematic illustrating front-end switches for an analog-to-digital converter (ADC) with shorting phase switches configured to provide a sense node according to one embodiment of the disclosure.

FIGURE 10 is a circuit schematic illustrating interface detection and compensation for an analog-to-digital converter (ADC) according to one embodiment of the disclosure.

FIGURE 11 is a flow chart illustrating an example method for determining microphone configuration and applying mismatch compensation according to one embodiment of the disclosure.

FIGURE 12 is a flow chart illustrating an example method for compensating undesired effects in an analog-to-digital converter (ADC) not covered by the invention as claimed.

FIGURE 13 is a flow chart illustrating an example method for sensing common mode (CM) data in an analog-to-digital converter (ADC) not covered by the invention as claimed.

## DETAILED DESCRIPTION

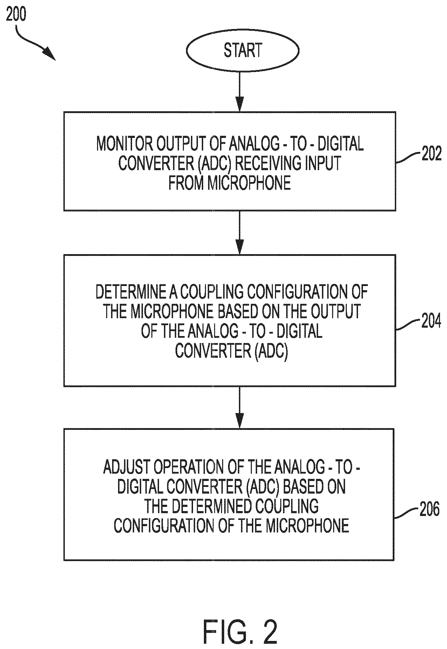

FIGURE 2 is a flow chart illustrating a method of detecting and adjusting operation of an analog-to-digital converter (ADC) to match a microphone topology according to one embodiment of the disclosure. A method 200 begins at block 202 with monitoring an output of an analog-to-digital converter (ADC) that is receiving analog input from a microphone. The monitored output may be, for example, a digital output or a pseudo-digital output from the ADC. Then, at block 204, a coupling configuration of the microphone may be determined based on the monitored output of the ADC at block 202. The determination may be made based on instantaneous values at the ADC output or the determination may be made by evaluating the ADC output over a certain period of time. Next, at block 206, the operation of the analog-to-digital converter (ADC) may be adjusted based on the determined coupling configuration of the microphone. The method 200 may be performed by a controller coupled to the analog-to-digital converter or a controller integrated with the analog-to-digital converter.

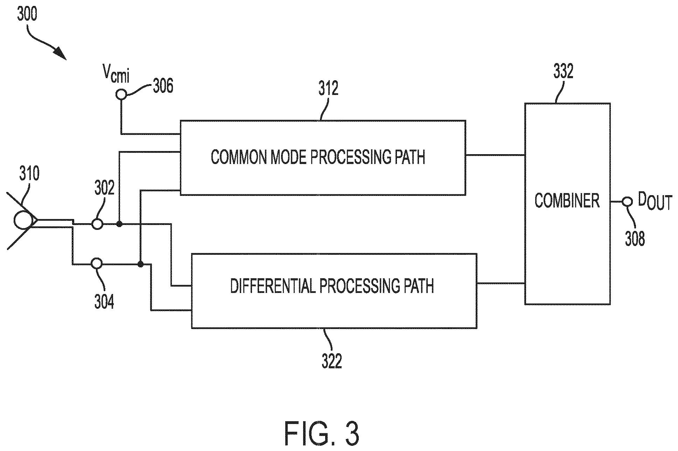

One method of processing the analog signal from a microphone in an ADC to determine microphone configuration as described in FIGURE 2 is to process the microphone input signals in two processing paths. A first processing path may process a difference between differential input signals, and a second processing path may process an average value of the differential input signals. FIGURE 3 is a block diagram illustrating a portion of an analog-to-digital converter (ADC) with two processing paths for processing analog signals according to one embodiment of the disclosure. An analog-to-digital converter (ADC) 300 may include a first input node 302 and a second input node 304. The input nodes 302 and 304 may be configured to couple to a microphone 310 to receive, as a differential or pseudo-differential input, an analog signal generated by the microphone 310 indicative of sounds in an environment around the microphone 310. Although only portions of the ADC 300 are illustrated in FIGURE 3, such as loop filter components, additional components not shown in FIGURE 3 may be present in an ADC.

The ADC 300 may process the input received at input nodes 302 and 304 to generate digital output $D_{out}$ at output node 308. Processing may occur through two processing paths 312 and 322. A differential processing path 322 may process a difference between the differential signal at input nodes 302 and 304. A common mode processing path 312 may process an average value of the differential inputs at input nodes 302 and 304. In one embodiment, the common mode processing path 312 may generate a difference between the average value of the differential inputs and an ideal common mode voltage $V_{CMI}$ received at an input node 306. Outputs of the processing paths 312 and 322 may be provided to combiner 332, which generates at least one digital output signal $D_{out}$ at output node 308.

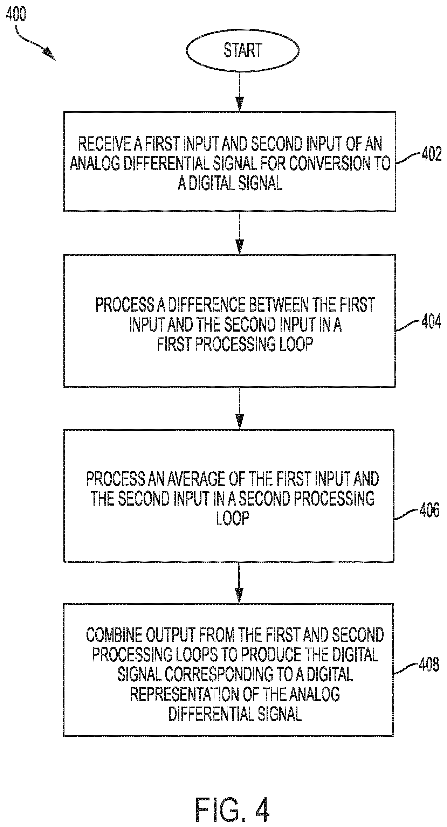

A method for processing an analog differential signal through an ADC configured with two processing paths as illustrated in FIGURE 3 is described with reference to FIGURE 4. FIGURE 4 is a flow chart illustrating a method of converting analog signals to digital signals in an analog-to-digital converter (ADC) with two processing paths according to one embodiment of the disclosure. A method 400 begins at block 402 with receiving a first input and a second input of an analog differential signal for conversion to a digital signal. Then, at block 404, a difference between the first input and the second input is processed in a first processing loop, such as the differential processing path 322 of FIGURE 3. Next, at block 406, an average of the first input and the second input is processed in a second processing path, such as in common mode processing path 312 of FIGURE 3. The processing of blocks 404 and 406 may occur simultaneously. In other embodiments, the processing of blocks 404 and 406 may occur in serial fashion for individual samples taken from the first input and the second input. Then, at block 408, the output of the difference processing of block 404 and the average processing of block 406 may be combined, such as in combiner 332 of FIGURE 3, to produce the digital signal. The digital signal produced by combining the outputs of the processing paths corresponds to a digital representation of the analog differential signal. When a microphone is coupled to the first input and the second input, this digital signal is a digital representation of sounds in an environment around the microphone.

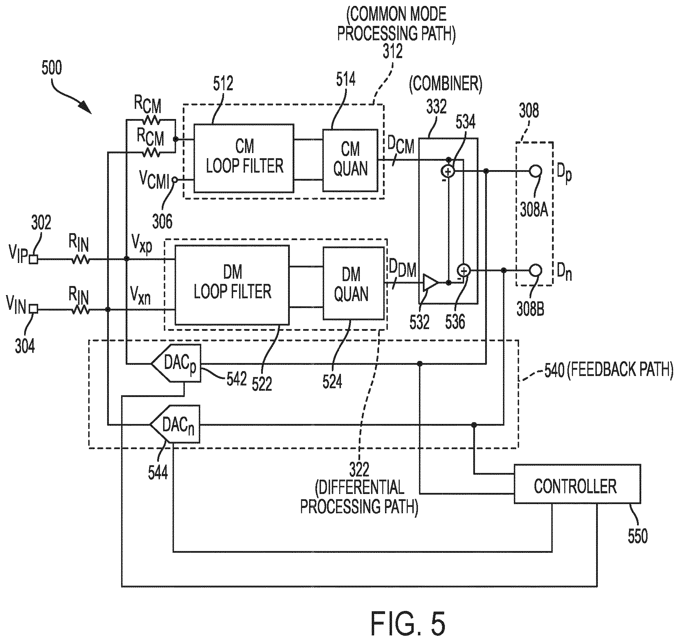

One embodiment for implementing an analog-to-digital converter (ADC) with two processing paths implements the two processing paths as delta-sigma modulators as shown in FIGURE 5. FIGURE 5 is a circuit schematic illustrating a portion of an analog-to-digital converter with two processing paths according to one embodiment of the disclosure. An analog-to-digital converter (ADC) 500 supports a universal microphone topology, which supports microphone topologies such as AC-coupled, DC-coupled, fully-differential, and pseudo-differential microphones. The first processing path 322 and the second processing path 312 include loop filters 522 and 512 and quantizers 524 and 514, respectively. The processing paths 312 and 322 output to combiner 332, which generates a pseudo-digital signal at output nodes 308A and 308B. The pseudo-digital signal at nodes 308A and 308B are provided through a feedback path 540 to inputs of the processing paths 312 and 322, respectively. The feedback path 540 includes digital-to-analog converters (DACs) 542 and 544. Outputs of the DACs 542 and 544 may be coupled to first and second inputs of the differential processing path 322, respectively. Further, the output of the DACs 542 and 544 may be averaged for input to the common mode processing path 312. Each of the processing paths 312 and 322 thus is a functional ADC loop coupled to the same front-end and back-end. However, each of the processing paths 312 and 322 processes different aspects of the input signal received at input nodes 302 and 304.

The input nodes 302 and 304 couple a differential signal to two front-end summing nodes $V_{xn}$, $V_{xp}$ and into the differential-mode (DM) loop filter 522. The input nodes 302 and 304 also couple an average of the differential signal to the common-mode (CM) loop filter 512. The common mode loop filter also receives an ideal CM voltage $V_{CMI}$ from input node 306, which may indicate a desired common mode voltage selected to match a desired input at amplifiers (not shown) within the loop filters 512 and 522. Thus, a differential error signal passes through the DM loop filter 522, and a common-mode error signal passes through the CM loop filter 512. The loop filters 512 and 522 may include, for example, integrators that contain operational amplifiers. Those operational amplifiers may be designed to operate in certain ranges that match the ideal common mode voltage $V_{CMI}$ received at node 306. The output of the loop filters 512 and 522 are quantized in quantizers 514 and 524, respectively, to generate digital outputs $D_{CM}$ and $D_{DM}$. The $D_{CM}$ digital output may contain a digital representation of an error signal based on comparing the average value of the inputs with the ideal common mode voltage $V_{CMI}$; the $D_{DM}$ digital output may contain a digital representation of an error signal based on the differential input at input nodes 302 and 304. After quantization, the CM and DM digital outputs, $D_{CM}$ and $D_{DM}$, are combined at combiner 332, such as by using a decoder to generate pseudo digital data, which carries CM and DM information. The pseudo-digital data may be output as $D_p$ and $D_n$ signals at nodes 308A and 308B, in which $D_p$ contains $(D_{CM}+D_{DM}/2)$ information, and $D_n$ contains $(D_{CM}-D_{DM}/2)$ information. The combiner may include an amplifier 532 and summation blocks 534 and 536 to generate the output $D_p$ and $D_n$ signals from the output of paths 312 and 322.

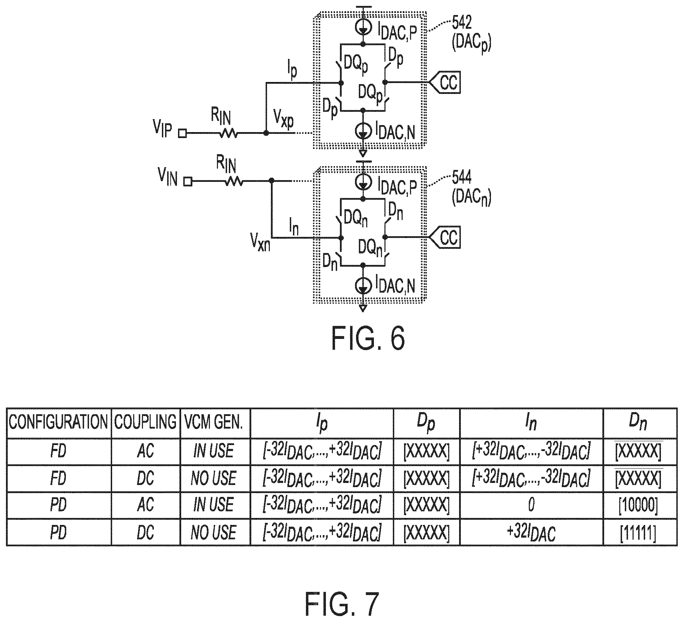

The pseudo-digital data $(D_n, D_p)$ may be coupled to DACs 544 and 542, respectively, in feedback path 540. In one embodiment, the DACs 544 and 542 may be implemented as current-steering DACs. FIGURE 6 is a circuit schematic illustrating digital-to-analog converters (DACs) from the feedback path of the analog-to-digital converter (ADC) according to one embodiment of the disclosure. In the DACs 542 and 544, the pseudo-digital output $D_p$ controls the switches of the current DAC in $DAC_p$ 542 and $D_n$ controls the switches of $DAC_n$ 544.

Operation of the ADC 500 of FIGURE 5 may be explained with reference to FIGURE 7, which is a table showing example outputs of the ADC 500 when configured as a 5-bit ADC. For the AC-coupled fully-differential microphone topology, the DC values of $V_{in}$ and $V_{ip}$ may be set to $V_{CMI}$ internally and the CM error may be zero. As a result, DAC 542 output value $I_p$ may sweep from $-32*I_{DAC}$ to $+32*I_{DAC}$, and DAC 544 output value $I_n$ may sweep from $+32*I_{DAC}$ to $-32*I_{DAC}$ resulting in an opposite code on $D_n$ and $D_p$. For the DC-coupled fully-differential topology, if the DC value of the inputs at nodes 302 and 304 is matched with $V_{CMI}$ at node 306, there will not be any common-mode error signal, and the output will be similar to that of the AC-coupled FD case. For the DC-coupled fully-differential topology, if the DC value of the inputs at nodes 304 and 304 is not matched with $V_{CMI}$ at node 306 (such that there is a CM error), then the CM loop filter 512 may adjust $I_p$ and $I_n$ values to offset that CM error. Then, the output again will be similar to that of the AC-coupled FD case. Thus, if a controller, such as controller 550 of FIGURE 5, detects an average of $D_n$ and $D_p$ digital output codes is zero, then the controller may determine that the microphone topology is fully-differential. The controller may further discriminate between the AC-coupled and DC-coupled variations of the fully-differential topology by receiving additional information. For example, the controller may receive a programmed signal from a memory or a fuse. In another example, the controller may determine an amount of current drawn from the $V_{CMI}$ input node 306.

For the AC-coupled pseudo-differential topology, DC values of $V_{ip}$ and $T_{in}$ may be set internally to match $V_{CMI}$ received at input node 306. Then, the $D_p$ and $I_p$ values may be similar to that of the AC-coupled FD case, but different in that the $I_n$ value will be zero $(D_n=[10000]$, which is the mid code), because there is no AC signal at node 304 for $V_{in}$ and its DC value is set by a $V_{cm}$ generator block (not shown). Thus, if a controller, such as controller 550 of FIGURE 5, detects a $D_n$ value of [10000], then the controller may determine that the microphone topology is AC-coupled pseudo-differential.

For the DC-coupled pseudo-differential topology, $D_p$ and $I_p$ values will be similar to that for the AC-coupled pseudo-differential topology (assuming the DC value on $V_{ip}$ matches $V_{CMI}$), but $I_p$ will max out at $+32*I_{DAC}$ to set the DC value of the $V_{xn}$ node, resulting in an output value $D_n=[11111]$. Thus, if a controller, such as controller 550 of FIGURE 5, detects a $D_n$ value of [11111], then the controller may determine that the microphone topology is DC-coupled pseudo-differential topology.

A controller may use a digital detection algorithm to detect the microphone topology by monitoring the data pattern on $D_p$ and $D_n$ and based on that distinguish the various topologies. In some embodiments, additional information may be provided to the controller to assist in the determination. After determining the microphone topology, the controller may adjust operation of the ADC based on the determined topology. For example, when the topology is pseudo-differential AC-coupled, the controller 550 may shut down DAC 544. Alternatively, a few units of the DAC 544 may remain switched on for determining mismatches. As another example, when the topology is pseudo-differential DC-coupled, the controller may shut down NMOS side current of DAC 544 to reduce power consumption. In some embodiments, the controller may wait to adjust operation of the DAC until a stable condition is achieved within the ADC. The stable condition may be reached after a certain amount of time has elapsed from start-up of the ADC or a signal first appearing at the input of the ADC. Alternatively, the stable condition may be reached when the output of the DAC reaches an expected signal. The controller 550 described herein may be integrated with the DAC or external to the DAC.

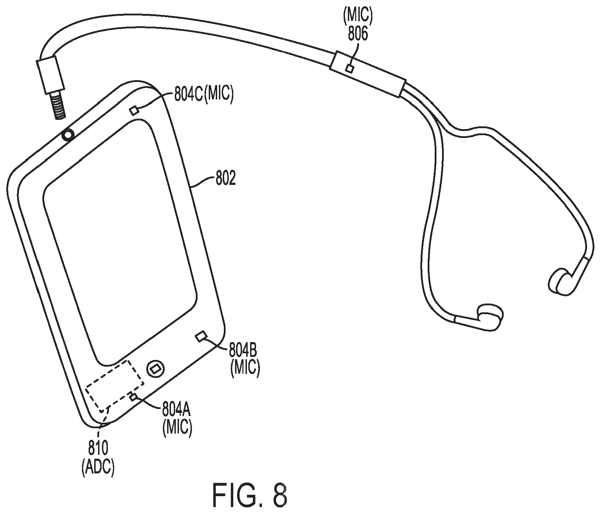

The DAC configurations described above as a universal and/or adaptive DAC for various microphone topologies may be implemented in an electronic device having microphones (or other analog input devices interacting with digital components). FIGURE 8 is an illustration showing an electronic device with an analog-to-digital converter (ADC) capable of operating microphones of different topologies according to one embodiment of the disclosure. A mobile device 802 may be, for example, a cellular telephone. Mobile devices 802 may include multiple microphones, such as speech microphones 804A and 804B, proximity microphone 804C for noise cancelling, and/or headset microphone 806. Microphones may be either integrated with the electronic device 802, such as microphones 804A, 804B, and 804C, or may be external to the electronic device 802, such as with microphone 806. An ADC 810 of the electronic device 802 may be coupled to the microphones 804A, 804B, 804C, and/or 806 to process input signals from the microphones 804A, 804B, 804C, and/or 806. The ADC 810 may incorporate two processing loops, such as described with reference to FIGURE 3, FIGURE 4, FIGURE 5, and FIGURE 6. The ADC 810 may also incorporate monitoring and adjustment capabilities described with reference to FIGURE 2 and FIGURE 7. The universal nature of the ADC 810 in supporting different topologies benefits end users in that the end user does not need to be aware of the microphone topology and benefits manufacturers in that the manufacture may switch microphone suppliers during production of an electronic device without also needing to change the ADC 810. Further, when the microphone is an AC-coupled topology, the interface between the ADC 810 and the microphone does not require coupling capacitors, such as capacitors 112 and 114 of FIGURE 1A and FIGURE 1B. Thus, the use of an ADC as disclosed herein can reduce space occupied by the microphone and ADC interface in an electronic device. Additional embodiments of an ADC or portions of an ADC that may be implemented in an electronic device, such as mobile device 802, are described below.

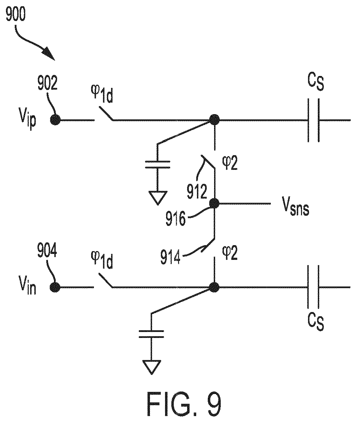

FIGURE 5 illustrates, and the description referencing FIGURE 5 describes, use of a feedback path 540 under operation by the controller 550 to apply signals to the differential nodes at $V_{xp}$ and $V_{xn}$, which are coupled to differential input nodes 302 and 304. In some embodiments, digital-to-analog converters (DACs) of the feedback path 540 may be used as an auxiliary digital-to-analog converter (DAC) to provide compensation for common mode and differential mode mismatches. In some of these embodiments, the auxiliary DACs may be controlled based on a measurement from a common mode (CM) sense node. A CM sense node may be provided through two or more switches coupled between the differential inputs. One such embodiment is shown in FIGURE 9 using shorting phase switches. FIGURE 9 is a circuit schematic illustrating front-end switches for an analog-to-digital converter (ADC) with shorting phase switches configured to provide a sense node according to one embodiment of the disclosure. A circuit 900 includes two shorting switches 912 and 914, which may be operated, such as by a controller (not yet shown), to short two input sampling caps during a second clock phase of operation. A sense node 916 between the two shorting switches 912 and 914 may provide a common mode (CM) sense node.

In particular, a voltage at the sense node 916 may provide data regarding an average voltage between the input nodes 902 and 904 during certain times of operation of the circuit 900. The shorting switches 912 and 914, along with any parasitic capacitance (not shown) between the switches 912 and 914, creates a switched-capacitor (SC) resistor. The SC resistor may have a large resistance value because the value is inversely proportional to the small parasitic cap value. The embodiment of FIGURE 9 uses switches to create two large resistors for providing the CM sense node. When the switches 912 and 914 are made conductive, the middle node 916 stabilizes to a voltage level that is approximately the average of the input voltage at input nodes 902 and 904.

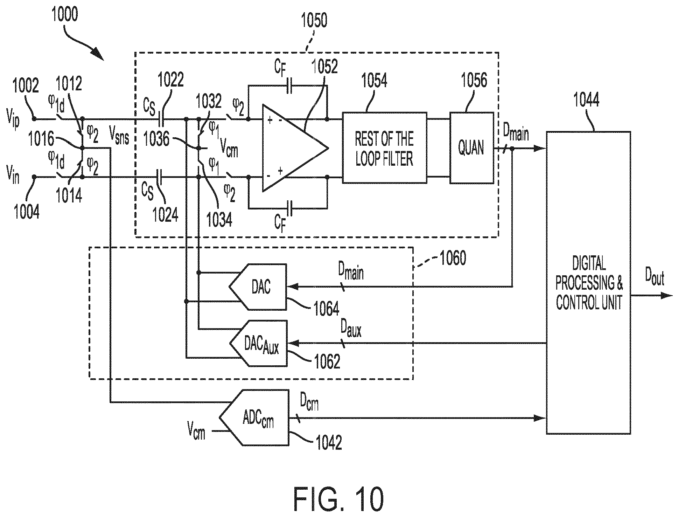

Input from the sense node 916 may be provided to a controller to operate DACs in a feedback path of an ADC. One embodiment of an ADC implementing feedback based on a CM sense node along with interface detection hardware similar to that described with reference to FIGURE 3 or FIGURE 5 is shown in FIGURE 10. FIGURE 10 is a circuit schematic illustrating interface detection and compensation for an analog-to-digital converter (ADC) according to one embodiment of the disclosure. Although a particular ADC configuration is shown in FIGURE 10, the sense node and/or controller described herein may be implemented in other ADC configurations, including switched-capacitor ADC circuits and continuous-time ADC circuits.

An analog-to-digital converter (ADC) circuit 1000 includes a first set of shorting switches 1012 and 1014 coupled on a first side of sampling capacitors 1022 and 1024, respectively. The shorting switches 1012 and 1014 couple differential input nodes 1002 and 1004 to a sense node 1016. The circuit 1000 also includes a second set of shorting switches 1032 and 1034 coupled on a second side of sampling capacitors 1022 and 1024, respectively. The shorting switches 1032 and 1034 couple the differential input to a node 1036, and the node 1036 may be the common mode $V_{cm}$ voltage.

The sense nodes 1016 may be measured and used to determine mismatch between an external common mode $V_{cm,p}$ and an internal common mode $V_{cm,i}$. The external common mode $V_{cm,p}$ may be monitored by controlling the switches 1012 and 1014 to enter conducting mode to allow the sense node 1016 to equilibrate to an average voltage between the differential input nodes 1002 and 1004 external to the ADC 1000. A digital-to-analog converter (DAC) 1042 may measure the external common mode $V_{cm,p}$ values. The ADC 1042 may generate a common mode value $D_{cm}$ based on the $V_{cm,i}$ and $V_{cm,p}$ values. That common mode value $D_{cm}$ may be provided to a controller 1044. Mismatch between the $V_{cm,i}$ and $V_{cm,p}$ values create a differential signal that may appear at an output of the circuit 1000 or create noise in the output of the circuit 1000, such that the output of the circuit 1000 may be improved by detecting the mismatch and compensating for the mismatch.

Compensation may be obtained through the feedback path 1060. The compensation may be provided through auxiliary DAC 1062 according to a digital code selected by the controller 1044 according to monitoring of the $D_{cm}$ and $D_{main}$ outputs. The differential input signal may be processed through ADC components 1050, such as through sampling capacitors 1022 and 1024, a comparator 1052, other loop filter components 1054, and a quantizer 1056 to generate a quantized output $D_{main}$. The quantized output $D_{main}$ may be provided to the controller 1044 and used by the controller 1044 to generate a digital output $D_{out}$ of the circuit 1000. The controller 1044 may also use the quantized output $D_{main}$ to generate control signals for controlling the feedback path 1060. The feedback path 1060 may include an auxiliary DAC 1062. The feedback path 1060 may also include main DAC 1064, which receives the quantized output $D_{main}$ and feeds the $D_{main}$ value back to the ADC 1000. The controller 1044 may generate control signals for operating the auxiliary DAC 1062, which applies a signal to the internal CM sense nodes to compensate for CM mismatch.

The controller 1044 may be configured to process the microphone interface configuration. The interface configuration may be determined, in part, from the quantizer 1056 output. The quantizer 1056 digital output code represents the differential-mode (DM) representation of the inputs. That is, after filtering quantization noise, the quantized output $D_{main}$ has $V_{ip}$-$V_{in}$ information, where $V_{ip}$ is an input at node 1002 and $V_{in}$ is an input at node 1004. The interface configuration may also be determined, in part, from the ADC 1042 output, which includes information from sense nodes 1016. By digitizing the sense node 1016 voltages, the controller 1044 may have the common-mode (CM) information, e.g. an indication of the value $(V_{ip}+V_{in})/2$, regarding the differential input voltages at input nodes 1002 and 1004. Using this DM and CM information, the controller 1044 may determine the interface configuration (e.g., either fully-differential FD or pseudo-differential PD), and the controller 1044 may also determine possible DM or CM mismatch of the differential input signals at input nodes 1002 and 1004.

The controller 1044 may determine the microphone is in pseudo-differential (PD) configuration when the DM output is at a mid-code centered output code and the CM data indicates an AC signal term appears at the sense node. If a pseudo-differential (PD) configuration is not detected, then the controller 1044 may determine that the microphone is operating in a fully-differential (FD) configuration. The controller 1044 may determine an AC mismatch is present when the CM data includes an AC signal term and the DM data has no code shift. The controller 1044 may determine a DC mismatch when the CM data does not indicate an AC signal term and the DM data has a code shift. The controller 1044 may determine an AC and DC mismatch is present when the CM data indicates an AC signal term and the DM data has a code shift. In any of these scenarios, the AC signal term on the CM input may be proportional to the input AC mismatch amplitude, and the code shift on the DM input may be proportional to the DC mismatch.

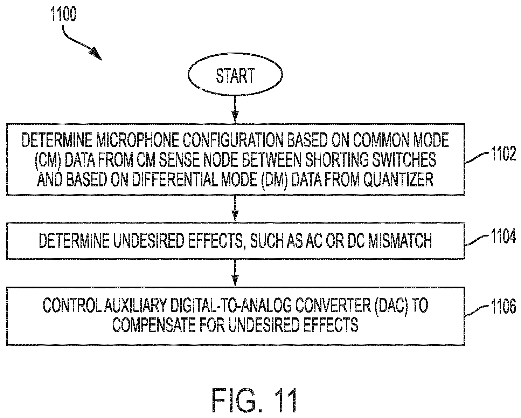

One method for operation of the controller 1044 is shown in FIGURE 11. FIGURE 11 is a flow chart illustrating an example method for determining microphone configuration and applying mismatch compensation according to one embodiment of the disclosure. A method 1100 begins at block 1102 with determining a microphone configuration based on common mode (CM) data and differential mode (DM) data. The CM data may be received as a signal indicative of a voltage level at a CM sense node, such as in the signal $D_{cm}$ from ADC 1042 in FIGURE 10. The DM data may be received as a signal from a quantizer in the differential mode path, such as the signal $D_{main}$ from the quantizer 1056 in FIGURE 10. Then, the method 1100 continues to block 1104, to determine undesired effects within the ADC from the microphone input. For example, block 1104 may include determining the presence of an AC or DC mismatch between the differential input nodes and/or the between the internal and the external common mode. Next, at block 1106, the method 1100 may include controlling components of the ADC, such as an auxiliary DAC, to compensate for the undesired effects of block 1104. For example, the auxiliary DAC 1062 may be controlled to apply a signal to the differential input of the ADC to compensate for mismatches.

The compensation of block 1106 may be applied to, for example, cancel a mismatched portion of input transferred charge. The total ADC input path charge for the differential inputs may be given by $q_{i,p}$ and $q_{i,n}$ as shown below:

$$q_{i,p} = C_i \left\{ V_{DMi} + \frac{\Delta V_{CMi} + \Delta V_{DMi}}{2} \right\}$$

$$q_{i,n} = C_i \left\{ -V_{DMi} - \frac{\Delta V_{CMi} + \Delta V_{DMi}}{2} \right\}$$

The DAC path charges of the differential inputs may be given by $q_{dac,p}$ and $q_{dac,n}$ as shown below:

$$q_{dac,p} = C_{dac,main} \cdot V_{refn,main}(D_{main}) + C_{dac,aux} \cdot V_{refn,aux}(D_{aux})$$

$$q_{dac,n} = C_{dac,main} \cdot V_{refp,main}(D_{main}) + C_{dac,aux} \cdot V_{refp,aux}(D_{aux})$$

An auxiliary DAC may be controlled to cancel the mismatched portion of the input transferred charge ($\frac{\Delta V_{CMi} + \Delta V_{DMi}}{2}$). In one embodiment, the controller 1044 may generate a digital code value $D_{aux}$ for output to the auxiliary DAC 1062 that causes the auxiliary DAC 1062 to apply sufficient charge to cancel the mismatched portion of the input transferred charge.

In some embodiments, the controller 1044 may take specific actions as part of the compensation step at block 1106. In the following examples, $V_{CM}$ refers to an external common mode, and $V_{cm,i}$ and $V_{cm,p}$ refer to the common mode at the inputs $V_{in}$ and $V_{ip}$, respectively. For example, when $D_{cm}$ has only a DC term (that may be proportional to $V_{cm,i} - V_{cm}$) and $D_{main}$ does not have a DC shift, the controller 1044 may determine the interface is fully differential (FD) with matched DC and AC values, and thus the generated $D_{aux}$ output may be neutral (such as set at a mid-code). As another example, when $D_{cm}$ has only a DC term (that may be proportional to $V_{cm,i} - V_{cm} + \Delta V_{cm,i}/2$) and $D_{main}$ has a DC shift (that may be proportional to $\Delta V_{cm,i}$), the controller 1044 may determine the interface is fully differential (FD) and the input DC values are mismatched, and thus the generated $D_{aux}$ output may be selected to compensate the undesired charge proportional to $\Delta V_{cm,i}/2$. As another example, when $D_{cm}$ has a DC term (that may be proportional to $V_{cm,i} - V_{cm}$) and an AC term (that may be proportional to $\Delta V_{dm,i}$) and $D_{main}$ does not have a DC shift, the controller 1044 may determine the interface is fully differential (FD) with matched DC input values but mismatched AC values, and thus the generated $D_{aux}$ output may be selected to compensate for the undesired charge proportional to $\Delta V_{dm,i}/2$. As a further example, when $D_{cm}$ has a DC term (that may be proportional to $V_{cm,i} - V_{cm} + \Delta V_{cm,i}/2$) and an AC term (that may be proportional to $\Delta V_{dm,i}$) and $D_{main}$ has a DC shift, the controller 1044 may determine the interface is fully differential (FD) with mismatched AC and DC values, and thus the generated $D_{aux}$ output may be selected to compensate the undesired charge proportional to $(\Delta V_{cm,i} + \Delta V_{dm,i})/2$. As another example, when $D_{cm}$ has a DC term (that may be proportional to $V_{cm,i}/2 - V_{cm}$) and an AC term (that may be proportional to $V_{dm,i}/2$), $D_{main}$ has no DC shift, $D_{cm}$ has a high DC term, and $D_{cm}$ has a high (e.g., $>= V_{dm,i}/2$) AC term, the controller 1044 may determine the interface is pseudo differential (PD), and thus the generated $D_{aux}$ output may be selected to compensate the undesired charge proportional to $V_{cm,i}/2$ to remove the DC shift on active block outputs.

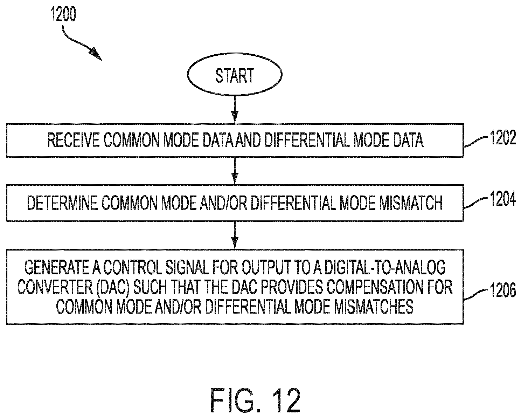

One example embodiment of determining undesired effects and applying compensation is described in more detail with reference to FIGURE 12. FIGURE 12 is a flow chart illustrating an example method for compensating undesired effects in an analog-to-digital converter (ADC) according to one embodiment of the disclosure. A method 1200 may begin at block 1202 with receiving common mode (CM) data and differential mode (DM) data. The received CM data and DM data may be, for example, an average of the differential input node voltages and a difference of the differential input node voltages, respectively. Then, at block 1204, undesired effects, such as common mode (CM) and/or differential mode (DM) mismatches may be determined. The CM mismatch and DM mismatch may be two unknowns calculated based, in part, on the received CM data and DM data from block 1202. Next, at block 1206, a control signal may be generated for output to a digital-to-analog converter (DAC), in which the control signal is selected such that the DAC provides compensation for at least some of the undesired effects determined at block 1204. For example, the DAC may be controlled to neutralize DC mismatch between the differential inputs.

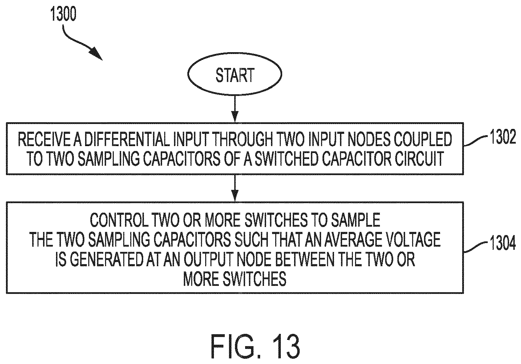

The CM data received at block 1202 may be received from a CM sense node within an ADC, such as the CM sense node 1016 of FIGURE 10. One example method for obtaining the CM data is described in more detail with reference to FIGURE 13. FIGURE 13 is a flow chart illustrating an example method for sensing common mode (CM) data in an analog-to-digital converter (ADC) according to one embodiment of the disclosure. A method 1300 may begin at block 1302 with receiving a differential input through two input nodes coupled to two sampling capacitors of a switched capacitor circuit. For example, a differential input may be received at input nodes 1002 and 1004 coupled to sampling capacitors 1022 and 1024 of FIGURE 10. Then, at block 1304, two or more switches may be controlled to sample the two sampling capacitors such that an average voltage is generated at an output node between the two or more switches. For example, switches 1012 and 1014 may be controlled to switch to a conducting state to sample an average voltage of sampling capacitors 1022 and 1024.

The schematic flow chart diagrams of FIGURE 2, FIGURE 4, FIGURE 11, FIGURE 12, and FIGURE 13 are generally set forth as a logical flow chart diagram. As such, the depicted order and labeled steps are indicative of aspects of the disclosed method. Additionally, the format and symbols employed are provided to explain the logical steps of the method and are understood not to limit the scope of the method. Although various arrow types and line types may be employed in the flow chart diagram, they are understood not to limit the scope of the corresponding method. Indeed, some arrows or other connectors may be used to indicate only the logical flow of the method. For instance, an arrow may indicate a waiting or monitoring period of unspecified duration between enumerated steps of the depicted method. Additionally, the order in which a particular method occurs may or may not strictly adhere to the order of the corresponding steps shown.

The operations described above as performed by a controller may be performed by any circuit configured to perform the described operations. Such a circuit may be an integrated circuit (IC) constructed on a semiconductor substrate and include logic circuitry, such as transistors configured as logic gates, and memory circuitry, such as transistors and capacitors configured as dynamic random access memory (DRAM), electronically programmable read-only memory (EPROM), or other memory devices. The logic circuitry may be configured through hard-wire connections or through programming by instructions contained in firmware. Further, the logic circuity may be configured as a general purpose processor capable of executing instructions contained in software. If implemented in firmware and/or software, functions described above may be stored as one or more instructions or code on a computer-readable medium or in the memory circuitry. Examples include non-transitory computer-readable media encoded with a data structure and computer-readable media encoded with a computer program. Computer-readable media includes physical computer storage media. A storage medium may be any available medium that can be accessed by a computer. By way of example, and not limitation, such computer-readable media can comprise random access memory (RAM), read-only memory (ROM), electrically-erasable programmable read-only memory (EEPROM), compact disc read-only memory (CD-ROM) or other optical disk storage, magnetic disk storage or other magnetic storage devices, or any other medium that can be used to store desired program code in the form of instructions or data structures and that can be accessed by a computer. Disk and disc includes compact discs (CD), laser discs, optical discs, digital versatile discs (DVD), floppy disks and Blu-ray discs. Generally, disks reproduce data magnetically, and discs reproduce data optically. Combinations of the above should also be included within the scope of computer-readable media.

In addition to storage on computer readable medium, instructions and/or data may be provided as signals on transmission media included in a communication apparatus. For example, a communication apparatus may include a transceiver having signals indicative of instructions and data. The instructions and data are configured to cause one or more processors to implement the functions outlined in the claims.

Although the present disclosure and certain representative advantages have been described in detail, it should be understood that various changes, substitutions and alterations can be made herein without departing from the scope of the disclosure as defined by the appended claims. Moreover, the scope of the present application is not intended to be limited to the particular embodiments of the process, machine, manufacture, composition of matter, means, methods and steps described in the specification. For example, although analog-to-digital converters (ADCs) are described throughout the detailed description, aspects of the invention may be applied to the design of other converters, such as digital-to-analog converters (DACs) and digital-to-digital converters, or other circuitry and components based on delta-sigma modulation. As another example, although microphone interfaces for analog-to-digital converters (ADCs) are described herein, the ADCs disclosed herein may be applied to any analog input device. As one of ordinary skill in the art will readily appreciate from the present disclosure, processes, machines, manufacture, compositions of matter, means, methods, or steps, presently existing or later to be developed that perform substantially the same function or achieve substantially the same result as the corresponding embodiments described herein may be utilized. Accordingly, the appended claims are intended to include within their scope such processes, machines, manufacture, compositions of matter, means, methods, or steps. The scope of the invention is defined in the appended claims.

### Claims

1. An apparatus (300, 500), comprising:

   a first input node (302) for receiving a first input of an analog differential signal;
   a second input node (304) for receiving a second input of the analog differential signal;
   a digital output node (308);
   an analog-to-digital converter configured to convert the analog differential signal
   into a digital signal at the digital output node, the analog-to-digital converter comprising:

   a first processing loop (322) configured to process a difference between the first input and the second input;
   a second processing loop (312) configured to process an average of the first input and the second input; and
   a combiner (332) configured to receive an output of the first processing loop, to receive an output of the second processing loop, and to generate the digital signal based, at least in part, on the output of the first processing loop and the output of the second processing loop; and

   a controller (550) configured coupled to the analog-to-digital converter and configured to perform steps comprising:

   determining a coupling configuration of an input device generating the
   first input and the second input to the coupled analog-to-digital converter, wherein determining the coupling configuration is based, at least in part, on the digital signal; and
adjusting operation of the analog-to-digital converter based, at least in
part, on the determined coupling configuration.

2. The apparatus of claim 2, wherein the step of determining the coupling configuration comprises at least one of:

determining the coupling configuration of the input device is AC-coupled fully-differential;
determining the coupling configuration of the input device is AC-coupled pseudo-differential;
determining the coupling configuration of the input device is DC-coupled fully-differential; and
determining the coupling configuration of the input device is DC-coupled pseudo-differential.

3. The apparatus of claim 1 or claim 2, wherein the combiner (332) is configured to output a pseudo-differential digital signal comprising a first component and a second component,

wherein the first component comprises digital data indicative of a summation of the output of the first processing path and the output of the second processing path, and
wherein the second component comprises digital data indicative of a difference of the output of the first processing path and the output of the second processing path.

4. The apparatus of any of claims 1 to 3, wherein the first processing path (322) comprises a first delta-sigma modulator loop (522, 524), and wherein the second processing path comprises a second delta-sigma modulator loop (512, 514).

5. The apparatus of any of claims 1 to 4, wherein the first input node and the second input node each comprise a microphone input node.

6. The apparatus of any of claims 1 to 5, wherein the apparatus comprises at least one of an entertainment device, a smart phone, a tablet computer, and a personal computer.

**Patentansprüche**

1. Einrichtung (300, 500), umfassend:

einen ersten Eingangsknoten (302) zum Empfangen eines ersten Eingangs eines analogen Differenzsignals;
einen zweiten Eingangsknoten (304) zum Empfangen eines zweiten Eingangs des analogen Differenzsignals;
einen Digitalausgangsknoten (308);
einen Analog-Digital-Wandler, der konfiguriert ist, das analoge Differenzsignal in ein Digitalsignal an dem Digitalausgangsknoten zu wandeln, wobei der Analog-Digital-Wandler umfasst:

eine erste Verarbeitungsschleife (322), die konfiguriert ist,
eine Differenz zwischen dem ersten Eingang und dem zweiten Eingang zu verarbeiten;
eine zweite Verarbeitungsschleife (312), die konfiguriert ist,
einen Mittelwert des ersten Eingangs und des zweiten Eingangs zu verarbeiten; und
einen Kombinierer (332), der konfiguriert ist, einen Ausgang der ersten Verarbeitungsschleife zu empfangen, einen Ausgang der zweiten Verarbeitungsschleife zu empfangen und das Digitalsignal zumindest teilweise basierend auf dem Ausgang der ersten Verarbeitungsschleife und dem Ausgang der zweiten Verarbeitungsschleife zu erzeugen; und
eine Steuereinheit (550), die konfiguriert mit dem Analog-Digital-Wandler gekoppelt und konfiguriert ist, Schritte durchzuführen, umfassend:

Bestimmen einer Kopplungskonfiguration einer Eingangsvorrichtung, die den ersten Eingang und den zweiten Eingang an den gekoppelten Analog-Digital-Wandler erzeugt, wobei Bestimmen der Kopplungskonfiguration zumindest teilweise auf dem Digitalsignal basiert; und
Einstellen des Betriebs des Analog-Digital-Wandlers zumindest teilweise basierend auf der bestimmten Kopplungskonfiguration.

2. Einrichtung nach Anspruch 2, wobei der Schritt des Bestimmens der Kopplungskonfiguration mindestens eines von Folgendem umfasst:

Bestimmen, dass die Kopplungskonfiguration der Eingangsvorrichtung AC-gekoppelt volldifferenziell ist;
Bestimmen, dass die Kopplungskonfiguration der Eingangsvorrichtung AC-gekoppelt pseudodifferenziell ist;
Bestimmen, dass die Kopplungskonfiguration der Eingangsvorrichtung DC-gekoppelt volldifferenziell ist; und
Bestimmen, dass die Kopplungskonfiguration der Eingangsvorrichtung DC-gekoppelt pseudodifferenziell ist.

**3.** Einrichtung nach Anspruch 1 oder 2, wobei der Kombinierer (332) konfiguriert ist, ein pseudodifferenzielles Digitalsignal auszugeben, das eine erste Komponente und eine zweite Komponente umfasst,

wobei die erste Komponente Digitaldaten umfasst, die eine Summierung des Ausgangs des ersten Verarbeitungspfads und des Ausgangs des zweiten Verarbeitungspfads angeben, und
wobei die zweite Komponente Digitaldaten umfasst, die eine Differenz des Ausgangs des ersten Verarbeitungspfads und des Ausgangs des zweiten Verarbeitungspfads angeben.

**4.** Einrichtung nach einem der Ansprüche 1 bis 3, wobei der erste Verarbeitungspfad (322) eine erste Delta-Sigma-Modulatorschleife (522, 524) umfasst und wobei der zweite Verarbeitungspfad eine zweite Delta-Sigma-Modulatorschleife (512, 514) umfasst.

**5.** Einrichtung nach einem der Ansprüche 1 bis 4, wobei der erste Eingangsknoten und der zweite Eingangsknoten jeweils einen Mikrofoneingangsknoten umfassen.

**6.** Einrichtung nach einem der Ansprüche 1 bis 5, wobei die Einrichtung mindestens eines von einer Unterhaltungsvorrichtung, einem Smartphone, einem Tabletcomputer und einem persönlichen Computer umfasst.

**Revendications**

**1.** Appareil (300, 500) comprenant :

un premier nœud d'entrée (302) destiné à recevoir une première entrée d'un signal différentiel analogique ;
un second nœud d'entrée (304) destiné à recevoir une seconde entrée du signal différentiel analogique ;
un nœud de sortie numérique (308) ;
un convertisseur analogique-numérique configuré pour convertir le signal différentiel analogique en un signal numérique au niveau du nœud de sortie numérique, le convertisseur analogique-numérique comprenant :

une première boucle de traitement (322) configurée pour traiter une différence entre la première entrée et la seconde entrée ;
une seconde boucle de traitement (312) configurée pour traiter une moyenne de la première entrée et de la seconde entrée ; et
un combinateur (332) configuré pour recevoir une sortie de la première boucle de traitement, pour recevoir une sortie de la seconde boucle de traitement et pour générer le signal numérique sur la base, au moins en partie, de la sortie de la première boucle de traitement et de la sortie de la seconde boucle de traitement ; et
un dispositif de commande (550) configuré pour être couplé au convertisseur analogique-numérique et configuré pour réaliser des étapes comprenant :

la détermination d'une configuration de couplage d'un dispositif d'entrée générant la première entrée et la seconde entrée, du convertisseur analogique-numérique couplé, dans lequel la détermination de la configuration de couplage est basée, au moins en partie, sur le signal numérique ; et
le réglage du fonctionnement du convertisseur analogique-numérique sur la base, au moins en partie, de la configuration de couplage déterminée.

**2.** Appareil selon la revendication 2, dans lequel l'étape de détermination de la configuration de couplage comprend au moins l'une des étapes suivantes :

la détermination de la configuration de couplage du dispositif d'entrée est en mode entièrement différentiel à couplage CA ;
la détermination de la configuration de couplage du dispositif d'entrée est en mode pseudo-différentiel à couplage CA ;
la détermination de la configuration de couplage du dispositif d'entrée est en mode entièrement différentiel à couplage CC ; et
la détermination de la configuration de couplage du dispositif d'entrée est en mode pseudo-différentiel à couplage CC .

3. Appareil selon la revendication 1 ou la revendication 2, dans lequel le combinateur (332) est configuré pour délivrer un signal numérique pseudo-différentiel comprenant une première composante et une seconde composante,

dans lequel la première composante comprend des données numériques représentatives d'une somme de la sortie du premier chemin de traitement et de la sortie du second chemin de traitement, et
dans lequel la seconde composante comprend des données numériques représentatives d'une différence de la sortie du premier chemin de traitement et de la sortie du second chemin de traitement.

4. Appareil selon l'une quelconque des revendications 1 à 3, dans lequel le premier chemin de traitement (322) comprend une première boucle de modulateur delta-sigma (522, 524), et dans lequel le second chemin de traitement comprend une seconde boucle de modulateur delta-sigma (512, 514).

5. Appareil selon l'une quelconque des revendications 1 à 4, dans lequel le premier nœud d'entrée et le second nœud d'entrée comprennent chacun un nœud d'entrée de microphone.

6. Appareil selon l'une quelconque des revendications 1 à 5, dans lequel l'appareil comprend au moins l'un d'un dispositif de divertissement, d'un smartphone, d'une tablette et d'un ordinateur personnel.

FIG. 1A
PRIOR ART

FIG. 1B
PRIOR ART

FIG. 1C
PRIOR ART

FIG. 1D
PRIOR ART

14

EP 4 213 395 B1

FIG. 1E
PRIOR ART

FIG. 1F
PRIOR ART

FIG. 1G
PRIOR ART

15

200

START

MONITOR OUTPUT OF ANALOG - TO - DIGITAL
CONVERTER (ADC) RECEIVING INPUT
FROM MICROPHONE
— 202

DETERMINE A COUPLING CONFIGURATION OF
THE MICROPHONE BASED ON THE OUTPUT
OF THE ANALOG - TO - DIGITAL
CONVERTER (ADC)
— 204

ADJUST OPERATION OF THE ANALOG - TO -
DIGITAL CONVERTER (ADC) BASED ON
THE DETERMINED COUPLING
CONFIGURATION OF THE MICROPHONE
— 206

FIG. 2

FIG. 3

400

START

RECEIVE A FIRST INPUT AND SECOND INPUT OF AN ANALOG DIFFERENTIAL SIGNAL FOR CONVERSION TO A DIGITAL SIGNAL — 402

PROCESS A DIFFERENCE BETWEEN THE FIRST INPUT AND THE SECOND INPUT IN A FIRST PROCESSING LOOP — 404

PROCESS AN AVERAGE OF THE FIRST INPUT AND THE SECOND INPUT IN A SECOND PROCESSING LOOP — 406

COMBINE OUTPUT FROM THE FIRST AND SECOND PROCESSING LOOPS TO PRODUCE THE DIGITAL SIGNAL CORRESPONDING TO A DIGITAL REPRESENTATION OF THE ANALOG DIFFERENTIAL SIGNAL — 408

FIG. 4

FIG. 5

FIG. 6

| CONFIGURATION | COUPLING | VCM GEN. | $I_p$ | $D_p$ | $I_n$ | $D_n$ |
|---|---|---|---|---|---|---|
| FD | AC | IN USE | $[-32I_{DAC},...,+32I_{DAC}]$ | [XXXXX] | $[+32I_{DAC},...,-32I_{DAC}]$ | [XXXXX] |
| FD | DC | NO USE | $[-32I_{DAC},...,+32I_{DAC}]$ | [XXXXX] | $[+32I_{DAC},...,-32I_{DAC}]$ | [XXXXX] |
| PD | AC | IN USE | $[-32I_{DAC},...,+32I_{DAC}]$ | [XXXXX] | 0 | [10000] |
| PD | DC | NO USE | $[-32I_{DAC},...,+32I_{DAC}]$ | [XXXXX] | $+32I_{DAC}$ | [11111] |

FIG. 7

FIG. 8

FIG. 9

EP 4 213 395 B1

FIG. 10

23

1100

START

DETERMINE MICROPHONE CONFIGURATION BASED ON COMMON MODE
(CM) DATA FROM CM SENSE NODE BETWEEN SHORTING SWITCHES
AND BASED ON DIFFERENTIAL MODE (DM) DATA FROM QUANTIZER — 1102

DETERMINE UNDESIRED EFFECTS, SUCH AS AC OR DC MISMATCH — 1104

CONTROL AUXILIARY DIGITAL-TO-ANALOG CONVERTER (DAC) TO
COMPENSATE FOR UNDESIRED EFFECTS — 1106

FIG. 11

1200

```
        ╭─────────╮
        │  START  │
        ╰─────────╯
             │
             ▼
┌────────────────────────────────────────────────────────────┐
│   RECEIVE COMMON MODE DATA AND DIFFERENTIAL MODE DATA        │──1202
└────────────────────────────────────────────────────────────┘
             │
             ▼
┌────────────────────────────────────────────────────────────┐
│  DETERMINE COMMON MODE AND/OR DIFFERENTIAL MODE MISMATCH     │──1204
└────────────────────────────────────────────────────────────┘
             │
             ▼
┌────────────────────────────────────────────────────────────┐
│  GENERATE A CONTROL SIGNAL FOR OUTPUT TO A DIGITAL-TO-ANALOG │
│  CONVERTER (DAC) SUCH THAT THE DAC PROVIDES COMPENSATION FOR │──1206
│  COMMON MODE AND/OR DIFFERENTIAL MODE MISMATCHES             │
└────────────────────────────────────────────────────────────┘
```

FIG. 12

1300

START

RECEIVE A DIFFERENTIAL INPUT THROUGH TWO INPUT NODES COUPLED TO TWO SAMPLING CAPACITORS OF A SWITCHED CAPACITOR CIRCUIT ──1302

CONTROL TWO OR MORE SWITCHES TO SAMPLE THE TWO SAMPLING CAPACITORS SUCH THAT AN AVERAGE VOLTAGE IS GENERATED AT AN OUTPUT NODE BETWEEN THE TWO OR MORE SWITCHES ──1304

FIG. 13

**REFERENCES CITED IN THE DESCRIPTION**

**Patent documents cited in the description**

- US 23616316, Zanbaghi
- US 82699615, Zanbaghi
- CA 2273658 A1
- US 2011276975 A1